# EUROPÄISCHE PATENTSCHRIFT

(11) **EP 0 797 227 B1**
(45) Veröffentlichungstag und Bekanntmachung des Hinweises auf die Patenterteilung: **19.11.2003**
(21) Anmeldenummer: 97104327.8
(22) Anmeldetag: 13.03.1997
(51) Int. Cl.: H01H 27/00, H01H 36/00, H03K 17/968, H03K 17/97, H03K 17/965

(54) **Anordnung zur Steuerung von elektrischen ansteuerbaren Geräten**
Device to control electrically controlled apparatus
Dispositif de commande d'appareils à commande électrique

(30) Priorität: 20.03.1996 DE 29605163 U; 17.02.1997 DE 19706169
(43) Veröffentlichungstag der Anmeldung: 24.09.1997
(73) Patentinhaber: E.G.O. ELEKTRO-GERÄTEBAU GmbH, 75038 Oberderdingen (DE)
(72) Erfinder: Schilling, Wilfried, 76703 Kraichtal (DE); Perrin, Wilhelm, 76199 Karlsruhe (DE); Platt, Nils, 74374 Leonbronn (DE)
(74) Vertreter: Patentanwälte Ruff, Wilhelm, Beier, Dauster & Partner

(56) Entgegenhaltungen:
- EP-A- 0 260 091
- EP-A- 0 497 191
- EP-A- 0 600 780
- WO-A-89/04543
- DE-A- 4 432 399
- GB-A- 2 034 043
- US-A- 3 711 672
- US-A- 3 852 558

## Beschreibung

Die Erfindung betrifft eine Anordnung zur Ansteuerung von elektrisch ansteuerbaren Geräten, insbesondere Elektrokochgeräten.

Der Erfindungsgegenstand kann bevorzugt Anwendung finden bei Haushaltsgeräten bzw. Kochstellensteuerungen als Geber für die Leistungssteuerung, insbesondere zum Betrieb von Glaskeramikkochfeldern oder dergleichen, bei denen eine oder mehrere Kochstellen bzw. manuelle Betätigungsglieder an einem Grundkörper aus magnetisch nicht wirksamem Werkstoff, wie einer Glaskeramik-Platte, angeordnet sind.

Bei Glaskeramikkochfeldern mit integrierter Steuerung und/oder Regelung der Kochstellen besteht wie bei anderen Geräten, beispielsweise elektrisch betriebenen Geräten, ein Problem darin, die Betätigungs- bzw. Bedienungsorgane günstig anzuordnen. Bei z.B. über mehrere Kochstellen einteilig durchgehender Glaskeramik-Platte muß diese zur Anordnung der genannten Organe aufwendig mit Durchgangsbohrungen für die die Organe tragenden Schalterwellen versehen werden. Die Glaskeramikscheibe kann auch gebogen bzw. gekrümmt ausgebildet und mit einem seitlich abgewinkelten Scheibenschenkel versehen werden, so daß die Bedienungsorgane seitlich angeordnet werden können. Die Reinigung der Grundkörper-Platte ist bei diesen Ausbildungen sehr erschwert, insbesondere durch die vorstehenden Betätigungsglieder und/oder Übertragungsglieder, beispielsweise die Schalterwellen. Die über das Übertragungsglied mit dem Betätigungsorgan verbundene Betriebs-Einstelleinheit, beispielsweise ein Steuerkasten, kann auch gesondert vom Kochfeld bzw. dem Grundkörper an einem gesonderten Sockel angeordnet werden, so daß die Bedienungseinheit einschließlich der Schalter- bzw. Drehknebel getrennt vom Grundkörper ausgebildet und angeordnet ist. In jedem Fall ergibt sich ein erheblicher konstruktiver Aufwand.

Es ist bereits ein Verfahren zur Ansteuerung des Betriebs eines Kochgeräts bekannt, bei dem unter einer Glaskeramikplatte Reed-Schalter angeordnet sind, die mit Hilfe eines einen Magneten aufweisenden Schiebers geschlossen werden können. Der Schieber ist oberhalb der Glaskeramikplatte angeordnet und wird längs einer Führungsschiene verschoben. (EP 497191).

Ebenfalls bekannt ist ein Befehlsschalter für ein Haushaltskochgerät (EP 600780), bei dem der Schalterknopf an der Außenseite einer Platte in einer Halterung drehbar gelagert ist. In dem Schalterknopf ist ein Magnet enthalten, der einen hinter der Platte angeordneten Magnetschalter aktivieren kann.

Weiterhin ist ein Steuersystem für ein elektrisches Kochgerät bekannt, bei dem ein einen Magneten enthaltendes Bedienelement an einer bestimmten Stelle einer Glaskeramikplatte gestellt werden kann, um einen unter der Platte angeordneten Schalter zu schließen und zu öffnen. Das Bedienelement hat keinerlei Führung (EP 342213).

Aus der US-PS 3711672 ist eine magnetisch gekoppelte Steuerung für ein Kochfeld bekannt, bei der auf der Oberseite einer aus nicht magnetischem Material bestehenden Kochfeldplatte ein Schieber in einer Vertiefung angeordnet ist. Der Schieber wird magnetisch mit einem unterhalb der Platte angeordneten bewegbaren Gegenelement gekoppelt. Bei Verschiebung des Schiebers wird das Gegenelement ebenfalls verschoben, wobei die Verschiebung des Gegenelements mechanisch zur Betätigung beispielsweise eines Potentiometers abgenommen wird.

Der Erfindung liegt die Aufgabe zugrunde, eine Anordnung zur Steuerung von elektrisch ansteuerbaren Geräten zu schaffen, bei der die Bedienung verbessert ist und insbesondere die Möglichkeit einer Reinigung erleichtert wird.

Zur Lösung dieser Aufgabe schlägt die Erfindung eine Anordnung mit den im Anspruch 1 genannten Merkmalen vor. Weiterbildungen der Erfindung sind Gegenstand von Unteransprüchen.

Das Bedienelement wird ausschließlich berührungsfrei an der Stelle gehaltert, an der es bedient werden soll, so daß es zu Zwecken der Reinigung auch leicht entfernt werden kann. Die Platte, beispielsweise eine Glaskeramikplatte, weist keinerlei Öffnungen, Durchgänge, Vertiefungen, Halterungen oder dgl. auf. Gleichzeitig erfolgt die Ermittlung der Lage des Bedienelements oder der Veränderung der Lage des Bedienelements ebenfalls berührungsfrei durch die Platte hindurch. Die Platte besteht dabei aus einem Material, das die Feldlinien praktisch ungeschwächt hindurchläßt. Das Bedienelement kann beispielsweise auf der Oberseite oder Vorderseite der Platte anliegen, wobei eine spezielle Ausgestaltung des direkt anliegenden Teils zu einer reibungsfreien bzw. reibungsarmen Bewegung beitragen kann. Unter einer berührungsfreien Halterung des Bedienelements soll hier verstanden werden, daß dieses ohne direkte mechanische Verbindung gehalten wird. Natürlich kann das Bedienelement die Platte berühren. Es ist aber weder an der Platte noch gar an der felderzeugenden Einrichtung mechanisch festgelegt.

Die Art der Bewegung des Bedienelements kann dabei je nach Wunsch ausgestaltet werden.

Erfindungsgemäß wird vorgeschlagen, einen Schalterknebel zu verwenden, der durch einen beispielsweise innenliegenden Signalleiter, wie ein Glasfaserkabel oder dergleichen, als Zwischenglied für eine Drehstellungs- oder andere Informationsübertragung geeignet ist. Der Leiter ist im Knebel festsitzend installiert, so daß er eine Brücke mit einem Eingang und einem Ausgang bildet. Im Schalter oder Knebel können zur Erhöhung der Betriebssicherheit mehrere solcher Übertragungs- bzw. Informationsbrücken eingesetzt sein.

Der Eingang des Glasfaserkabels bzw. strangförmigen Signaloder Lichtleiters wird mit einer Signal- bzw. Lichtwelle beaufschlagt, deren Signal berührungsfrei von mindestens einem Signal-Sensor, wie einem fotoelektrischen Element, aufgenommen und einer beispielsweise elektronischen Auswertungs-Einheit zugeführt sowie dort so umgesetzt wird, daß die Leistungseinstell-Einheit in Abhängigkeit von der Knebelstellung auf unterschiedliche Betriebsstufen bzw. Betriebszustände eingestellt wird.

Für eine mögliche Codierung kann die Lichtquelle bereits moduliert und/oder mit einem oder mehreren Bildmustern versehen werden. Ähnliche Wirkungen können durch magnetisch wirkende Sensoren im Schalter bzw. Knebel selbst bewerkstelligt sein, wobei dann hier entsprechende zusätzliche Baugruppen vorzusehen sind. Bei Mehrfachbrücken im Schalter bzw. Knebel können durch jeweils vorhandene eingesetzte Bildmuster zusätzliche Bildmusterfolgen zur Freigabe herangezogen werden.

Das drehbare Bedienungsorgan bzw. der Knebel oder dergleichen kann zwar durch formschlüssigen Eingriff, z.B. in eine sacklochartige Zentrieröffnung in dem Grundkörper, gegen seitliches Verschieben zentriert sein, ist jedoch axial am Grundkörper zweckmäßig nur durch berührungsfrei wirkende Haltekräfte, wie Magnetkräfte, gegen Abheben gesichert.

In Weiterbildung der Erfindung kann vorgesehen sein, daß die Einrichtung zum Feststellen der Lage und/oder der Änderung der Lage des Bedienelements mindestens einen Sensor aufweist, der auf der gleichen Seite der Platte angeordnet ist wie die Einrichtung zur Erzeugung des Kraftfelds. Bei einem Elektroherd mit einer Glaskeramikplatte ist dies die Unterseite der Platte. Der Sensor wird dabei so angeordnet, daß das Bedienelement in Wechselwirkung mit ihm treten kann. Es kann sich bei dem Sensor auch um ein komplizierteres Gebilde handeln, beispielsweise eine Lichtquelle und eine Photozelle, so daß eine Reflexion von Licht an dem Bedienelement zur Ermittlung der Lage des Bedienelements herangezogen werden kann.

Erfindungsgemäß kann vorgesehen sein, daß der Sensor durch die gleiche physikalische Erscheinung beeinflußbar ist, die auch zum Festhalten des Bedienelements verwendet wird. Beispielsweise kann es sich um ein Magnetfeld handeln.

Es kann dabei in Weiterbildung der Erfindung auch vorgesehen sein, daß der Sensor durch das zum Festhalten des Bedienelements verwendete Feld selbst direkt beeinflußbar ist.

Es ist aber auch möglich, daß der Sensor auf eine andere physikalische Größe anspricht als die zum Festhalten des Bedienelements verwendete Größe. Beispielsweise kann das Bedienelement magnetisch festgehalten werden, während der Sensor auf eine Änderung einer Induktivität, einer Kapazität oder einer Reflexion anspricht.

In Weiterbildung der Erfindung kann vorgesehen sein, daß das Bedienelement derart festgehalten wird, daß es in nur einem Freiheitsgrad bewegbar ist. Unter der Bewegbarkeit in einem Freiheitsgrad ist die Möglichkeit zu verstehen, wie das Bedienelement bewegt werden kann, um eine Ansteuerung des elektrischen Geräts durchzuführen. Es kann sich dabei beispielsweise um eine Verschiebung oder aber insbesondere um eine Verdrehung um eine feste Achse handeln.

In nochmaliger Weiterbildung der Erfindung kann vorgesehen sein, daß für die Bewegung des Bedienelements eine Rasterung vorgesehen wird, die ebenfalls berührungsfrei arbeitet. Die Rasterung führt dazu, daß der Benutzer einer solchen Anordnung eine fühlbare Rückmeldung darüber erhält, daß das Bedienelement tatsächlich verstellt wird. Damit entsteht für den Benutzer ein bei elektrischen Kochgeräten üblicherweise vorhandenes Gefühl beim Bedienen.

In Weiterbildung der Erfindung kann vorgesehen sein, daß ein Inkrementalgeber mit dem Sensor verbunden ist, der feststellt, wie stark oder wie weit das Bedienelement bewegt wird. Eine mehr oder weniger große Änderung der Ansteuerung wird daher durch ein mehr oder weniger weites Verstellen des Bedienelements bewirkt. Eine solche Möglichkeit ist gerade bei einer berührungsfreien Halterung des Bedienelements und bei einer Verstellung durch Verdrehung von großem Vorteil, da es keine mechanische Nullstellung oder Endstellung des Bedienelements gibt.

Erfindungsgemäß ist jedoch auch die Möglichkeit eines Absolutgebers vorgesehen, bei der also die tatsächliche Stellung des Bedienelements ermittelt wird. Eine solche Möglichkeit ist insbesondere bei solchen Bedienelementen vorgesehen, die längs einer Linie verschoben werden können.

Erfindungsgemäß kann der mindestens eine Sensor mit einer Auswertelogik verbunden sein. Diese Auswertelogik dient dazu, beispielsweise eine Rechtsdrehung von einer Linksdrehung zu unterscheiden, damit ein Verstellen beispielsweise einer Leistungsregelung nach oben und nach unten möglich ist.

Die Anordnung kann in Weiterbildung auch eine Abschaltautomatik aufweisen, die dann, wenn alle Bedienelemente auf null gestellt werden, zu einer vollständigen Abschaltung des Geräts führt, so daß zum Wiedereinschalten eine anderer Vorgang verwendet werden muß.

Es kann erfindungsgemäß auch vorgesehen sein, daß die Anordnung durch einen Hauptschalter abgeschaltet und wieder eingeschaltet werden kann. Die Betätigung des Hauptschalters kann beispielsweise ebenfalls durch das Bedienelement erfolgen, das dann einfach an eine andere Stelle der Platte gebracht werden kann.

Erfindungsgemäß weisen die Einrichtung zum Erzeugen eines Kraftfelds mindestens einen ortsfest gehaltenen Magneten und das Bedienelement ein mit diesem zusammenwirkendes Element aus ferromagnetischem Material auf, wobei die Anordnung des Magneten den Freiheitsgrad der Bewegung definiert. Das an dem Bedienelement angeordnete Element aus ferromagnetischem Material kann beispielsweise ein Weicheisen sein, das von dem Magneten angezogen wird. Es kann sich aber auch um einen Magneten selbst handeln.

In Weiterbildung der Erfindung kann vorgesehen sein, daß ein einzelner Magnet derart an der Unterseite der Platte angeordnet wird, daß seine magnetische Achse senkrecht zu der Platte verläuft. Diese magnetische Achse kann dann eine Drehachse für das Bedienelement bilden, das bezüglich dieser Achse zentriert gehalten wird und sich dann um diese Achse verdrehen läßt.

In Weiterbildung kann vorgesehen sein, daß an dem Magnet ein mindestens zwei Arme aufweisendes Blechteil aus ferromagnetischem Material angebracht ist, dessen Arme in ihrem Endbereich der Platte angenähert sind. Hierdurch kann ein zweiter geschlossener magnetischer Kreis gebildet werden, der die Feldlinien zu einer bestimmten Stelle bündelt. Dadurch wird praktisch ein Magnetpol im Nebenschluß gebildet, der in diesem Fall ortsfest ist und in Zusammenwirken mit dem Betätigungselement eine Rastung bewirken kann.

Erfindungsgemäss weisen alternativ die Einrichtung zum Erzeugen eines Feldes einen bewegbar gehalterten Magneten und das Bedienelement ein mit diesem zusammenwirkendes Bauteil aus ferromagnetischem Material auf, wobei die Halterung für den Magneten den Freiheitsgrad der Bewegung des Bedienelements definiert. Läßt sich beispielsweise der Magnet unter einer Glaskeramikplatte verschieben, so kann diese Verschiebung durch die Verschiebebewegung des Bedienelements bewirkt werden.

Insbesondere kann mit dem bewegbaren Magneten ein Bauteil mit bewegt werden, dessen Bewegung von den Sensoren erfaßt wird. Der Sensor erfaßt damit nicht die Lage und/oder Änderung der Lage des Bedienelements direkt, sondern mittelbar über eine durch das Bewegen des Bedienelements hervorgerufene Änderung der Lage eines zweiten Bauteils.

Insbesondere kann vorgesehen sein, daß der Magnet an der Unterseite der Platte um eine ortsfeste Achse verdrehbar gehaltert ist. Dann kann mit ihm beispielsweise eine Scheibe verdreht werden, die eine Kodierung aufweist. In diesem Fall ist es sinnvoll, daß die magnetische Achse des Magneten parallel zu der Platte verläuft und daß das Bedienelement ebenfalls einen Magneten aufweist, dessen Achse ebenfalls parallel zur der Platte verläuft. Die beiden Magnete stellen sich dann antiparallel zueinander und bleiben auch so, wenn das Bedienelement verdreht wird.

Erfindungsgemäß kann in nochmaliger Weiterbildung vorgesehen sein, daß der Magnet derart bewegbar gehaltert wird, daß er durch Wechselwirkung mit dem Bedienelement in seine Betriebsposition gebracht und nach Wegnahme des Bedienelements in eine Warteposition bewegt werden kann. Beispielsweise kann der Magnet an der Unterseite einer Glaskeramikplatte um eine horizontale Achse nach unten wegklappen, wenn das Bedienelement von der Oberseite der Glaskeramikplatte abgenommen wird. Wird das Bedienelement wieder in die richtige Position geschoben, klappt der Magnet wieder zurück.

Diese Bewegung des Magneten an der Unterseite der Platte kann dazu ausgenutzt werden, einen Schalter zu betätigen, der eine galvanische Leitungstrennung bewirkt.

Weitere Merkmale, Einzelheiten und Vorzüge der Erfindung ergeben sich aus den Patentansprüchen, deren Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Fig. 1: ein Glaskeramik-Kochfeld in perspektivischer Gesamtübersicht;
- Fig. 2: eine Schalterknebel-Anordnung des Gerätes gemäß Fig. 1 in vergrößerter und teilweise geschnittener Seitenansicht;
- Fig. 3: eine schematische Darstellung eines verdrehbaren Bedienelements bei einer Glaskeramikplatte;
- Fig. 4: eine schematische Draufsicht auf die Anordnung der Fig. 1, soweit sie unterhalb der Platte angeordnet ist;
- Fig. 5: eine der Fig. 3 entsprechende Darstellung einer zweiten Ausführungsform;
- Fig. 6: eine Darstellung mit einer Abschaltung;
- Fig. 7: eine Aufsicht auf ein Teil eines Bedienelements bei einer geänderten Ausführungsform;
- Fig. 8: eine der Fig. 5 entsprechende Darstellung bei der Ausführungsform nach Fig. 7;
- Fig. 9: eine Aufsicht auf die Sensoren für die Ausführungsform der Fig. 8;
- Fig. 10: eine der Fig. 3 entsprechende Darstellung bei einer Ausführungsform, bei der der Magnet unterhalb der Platte weggeklappt werden kann;
- Fig. 11: schematisch die Verbindung zwischen Bedienelement, Sensor und Auswerteelektronik.

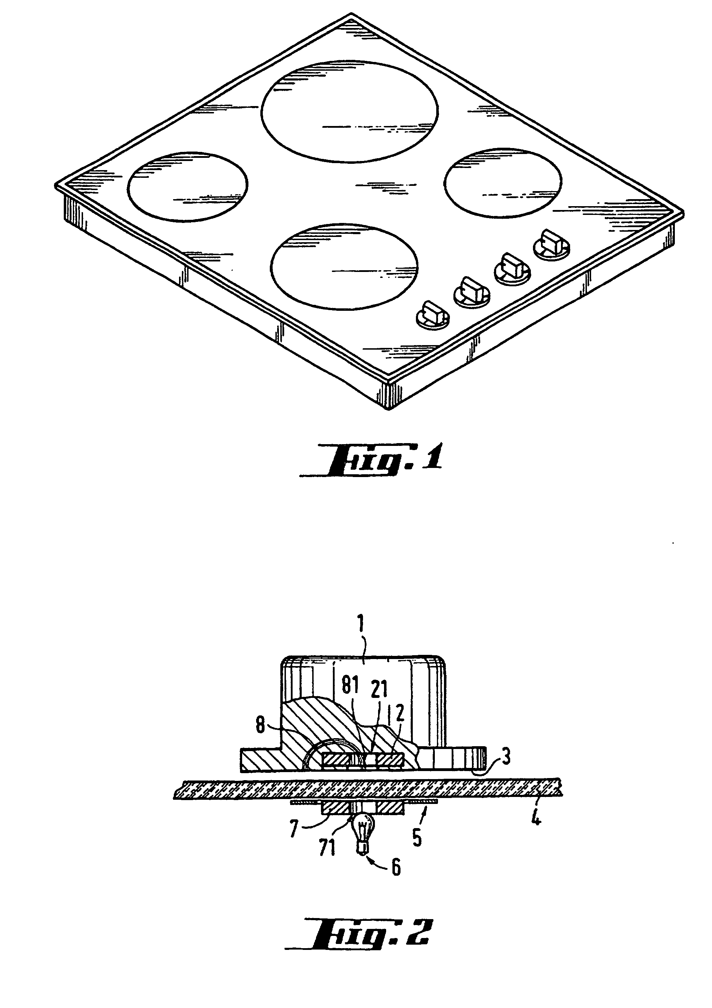

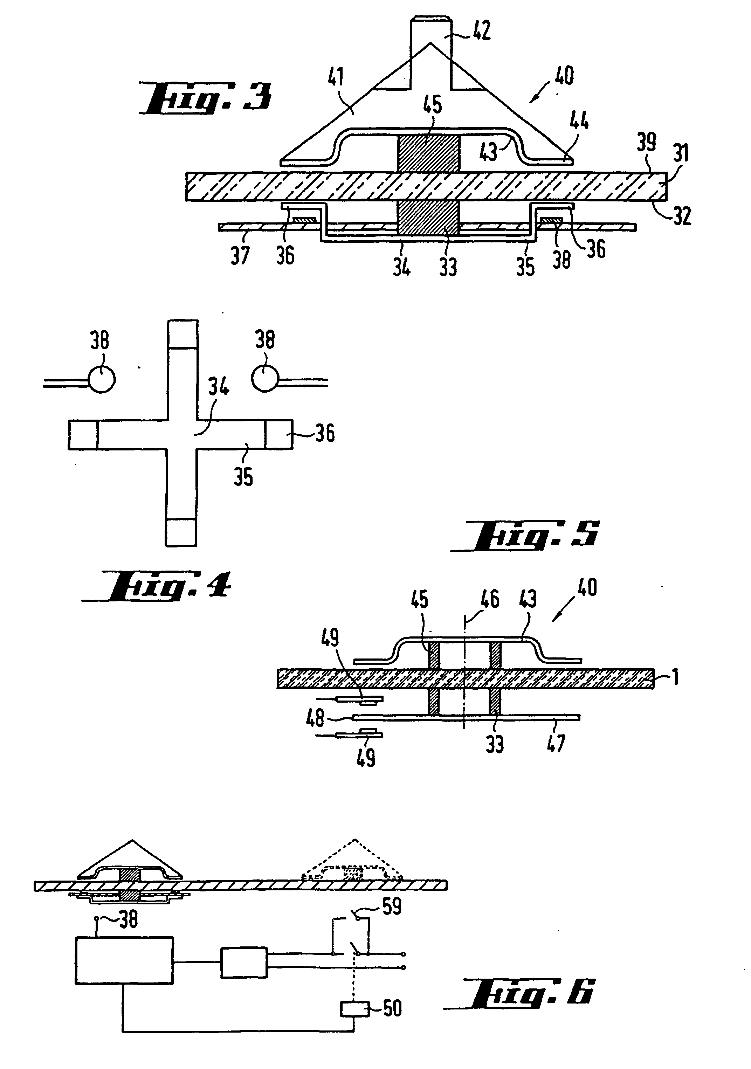

Gemäß den Figuren 1 und 2 weist das Kochfeld als Grundkörper eine von einem gesonderten Rahmen umgebene Glaskeramikplatte 4 mit einer einzigen oder mehreren im Abstand voneinander liegenden Kochstellen auf. Die Beheizungen, beispielsweise Strahlungsheizkörper, für die Kochstellen sind an der Rück- bzw. Unterseite der Platte angeordnet und geben ihre Heizstrahlung durch die Platte hindurch an deren Vorder- bzw. Oberseite ab, auf welche Kochgefäße gestellt werden können. An der Oberseite der durchgehend ebenen bzw. konstant dicken Platte liegen in einer Reihe benachbart zueinander bzw. nebeneinander mehrere Betätigungsglieder 1, mit welchen die einzelnen Beheizungen unabhängig voneinander manuell gesteuert, beispielsweise ein- und ausgeschaltet sowie auf unterschiedliche Betriebsleistungen im wesentlichen stufenlos eingestellt werden können. Die Betätigungsglieder 1 liegen hier zwischen den Kochfeldern und einer Außenkante der Platte unmittelbar benachbart sowie etwa in einer Reihe parallel zu dieser Außenkante. Die Betätigungsglieder 1 sind im Abstand nebeneinander angeordnet und können an der Oberseite der Platte mit ihren unteren Endflächen anliegen.

Um eine design- und funktionsgerechte konstruktive Lösung zur Erzielung der erfindungsgemäßen Wirkungen zu schaffen, ist als jeweiliges Betätigungsglied 1 der üblicherweise bei solchen Geräten verwendete Kunststoff-Knebel 1 verwendet, der an der Außenseite einer Rundscheibe einen Griffsteg zum Fassen mit den Fingern einer Hand aufweist und mit der Innenseite 3 der Rundscheibe parallel zur Platte 4 liegt sowie an deren Oberseite anliegt. Griffsteg und Rundscheibe sind einteilig miteinander ausgebildet.

In der Mitte bzw. Drehachse und im Bereich der inneren Stirnfläche 3 des Knebels 1 befindet sich eine z.B. ringförmig durchbrochene, magnetisierbare Scheibe 2 aus ferromagnetischem Werkstoff. Durch ein Signal-Fenster bzw. einen Durchbruch 21 im Zentrum dieser Scheibe 2 ist ein Signalleiter 8 bzw. Glasfaserkabel in den Knebel 1 eingelassen, das im wesentlichen vollständig in den Werkstoff des Knebels 1 festsitzend eingebettet sein kann. Beide Enden des durchgehend konstante Querschnitte aufweisenden Glasfaserstranges 8 schließen bündig mit der stirnseitigen Auflageseite 3 bzw. Endfläche des Knebels 1 ab, wobei das eine Ende 81 der so gebildeten Signalbrücke 8 mittig bzw. in der Achse des Knebels 1 angeordnet ist. Zwischen seinen beiden Enden ist der Signalleiter 8 annähernd halbkreisförmig gekrümmt, so daß die beiden Endflächen der Brücke 8 in einer gemeinsamen Ebene liegen können, jedoch am Außenumfang beide vom Werkstoff des Knebels 1 ummantelt sind. In dem Bereich, in welchem der Signalleiter 8 das ringscheibenförmige Glied 2 durchsetzt, braucht er nicht in den Werkstoff des Hebels 1 eingebettet zu sein.

Das gegenüber der Endfläche 3 geringfügig zurückversetzte Glied 2 ist jedoch vollständig in den Werkstoff des Knebels 1 festsitzend eingebettet und allseitig von diesem Werkstoff abgedeckt. An der der Platte 4 zugekehrten Seite bildet dieser Werkstoff eine dünne Abedeckung der zugehörigen Stirnfläche des Gliedes 2, wobei diese Abdeckung auch den Durchbruch 81 überdeckt und verschließt, jedoch vom zugehörigen Ende 81 des Signalleiters 8 durchsetzt ist. Die Endfläche 3 kann über ihre gesamte Erstreckung und die hauchdünne Abdeckung durchgehend eben oder zur Verminderung der Reibung gegenüber der Platte 4 nur durch einzelne Noppen oder Stege gebildet sein.

Unterhalb der Platte 4 bzw. an deren vom Knebel 1 abgekehrten Innenseite ist ein scheibenartiger oder ringförmiger Magnet 7, ggf. unmittelbar an der Platte 4, festsitzend angebracht. Radial benachbart zum bzw. um den Magnet 7 befinden sich in einem Kranz um die Drehachse des Knebels 1 fotoelektrische Elemente 5, die ebenfalls unmittelbar an der Platte 4 befestigt sein können. Darunter ist eine Lichtquelle 6 angeordnet, die an der Platte 4 unmittelbar lagegesichert sein kann, durch den zentralen Durchbruch 71 des Gliedes 7 strahlt und gegenüber dem die Elemente 5 abgeschirmt sein können. Die beiden Glieder 2, 7 können gleiche Innen- und/oder Außenweite bzw. Dicke haben und aus demselben Werkstoff bestehen sowie koaxial zueinander liegen.

Die eine Endfläche des Signalleiters 8 bildet den Signaleingang und die andere Endfläche den Signalausgang. Zweckmäßig ist die in der Drehachse liegende Endfläche als Signaleingang vorgesehen, so daß auch die Lichtquelle 6 in derselben Achse angeordnet ist und in jeder Drehstellung des Knebels 1 gleichermaßen gegen den Signaleingang strahlen kann.

Das Signal, nämlich Licht, wird von der Lichtquelle 6 durch den Durchbruch 71, dann durch die Platte 4 und schließlich in den Signaleingang gesendet, von welchem es entlang der Brücke 8 zum Signalausgang gelangt und dort entgegengesetzt zum Signaleingang, jedoch ebenfalls parallel zur Drehachse gerichtet ist. Vom Signalausgang gelangt das Licht zurück durch die Platte 4 gegen den Sensorkranz 5, dessen Radialabstand von der Drehachse gleich groß wie derjenige zwischen Signaleingang und Signalausgang sein kann. Je nach Drehstellung trifft das Licht auf ein anderes der fotoelektrischen Elemente 5.

Das so übertragene Signal wird dann einer nicht näher dargestellten Auswertschaltung zugeführt und von dieser zur Steuerung der zugehörigen Einstelleinheit umgesetzt.

In dem vom Knebel 1 bzw. der Steueranordnung 5, 6, 7, 71 abgedeckten Bereich ist die Platte 4 von Durchbrechungen frei, da kein Übertragungsglied bzw. keine Schalterwelle für die Signalübertragung benötigt wird. Zur Lagesicherung des Knebels 1 gegenüber der Platte 4 sind zweckmäßig Feldkräfte, wie magnetische Kräfte, vorgesehen. Diese Kräfte können den Knebel 1 axial gegen Abheben und/oder radial gegen seitliches Verschieben sichern, wobei jedoch zweckmäßig für die radiale Sicherung bzw. Zentrierung mechanisch ineinander greifende bzw. aneinander gleitende Glieder vorgesehen sein können.

Die Halterung des Knebels 1, die auch gesondert von den Gliedern zur Signalübertragung ausgebildet sein kann, ist hier in deren Bereich vorgesehen, nämlich durch die Glieder 2, 7 gebildet. Der unter der Platte 4 liegende Magnet 7 bringt soviel Kraft auf, daß der sich oben befindende Knebel 1 aufrund seines in ihm vollständig umschlossenen bzw. eingebetteten Haltegliedes 2 in seiner axialen bzw. radialen Position fixiert wird und trotzdem gegenüber den Teilen 4, 5, 6 drehbar gelagert ist. Der Knebel 1 ist trotzdem manuell und ohne Werkzeug durch Aufbringen einer entsprechend hohen Kraft aus seiner Betriebslage axial von der Schalterblende bzw. der Platte 4 abhebbar oder aus seiner gegenüber der Ringanordnung 5, 7 zentrierten Lage radial entlang der Platte 4 aus dem Kraftfeld des Magneten 7 verschiebbar.

Bei Anwendung der erfindungsgemäßen Ausbildung für eine Kochstellensteuerung ergibt sich der wesentliche Vorteil, daß wie bei Berührungsschaltern keine Durchbrüche in der Glaskeramikoberfläche bzw. Platte 4 benötigt werden. Der z.B. um die Drehachse mit mehreren Brücken 8 ausgestattete Knebel 1 wird entsprechend der Bildmusterkodierung die Leistungsstufen über die Sensoren 5 anwählen, wobei jeder Brücke 8 ein Bildmuster zugeordnet ist.

Durch das einfache Entfernen des Knebels 1 aus der Betriebslage kann eine Sicherung gegen unbefugtes Betätigen durch Kinder oder dgl. bewirkt werden. Sind alle Knebel 1 von der Glaskeramikoberfläche entfernt, so bildet die Platte 4 eine um das Bedienungsfeld der Knebel 1 erweiterte bzw. vergrößerte Arbeitsplatte innerhalb einer die Platte 4 aufnehmenden, größeren Gesamtplatte, ohne daß die vergrößerte Arbeitsfläche durch die Knebel 1 behindert wäre. Auch die Reinigung der Glaskeramikoberfläche wird durch das Entfernen der Knebel 1 wesentlich vereinfacht.

Gegen seitliches Verschieben entlang der Platte 4 kann das Betätigungsglied 1 formschlüssig z.B. dadurch gesichert werden, daß ein Zentrierglied durch Haftung bzw. Klebung an der Oberseite der Platte 4 festsitzend befestigt ist. Dieses Sicherungs- bzw. Zentrierglied, beispielsweise ein Konus aus Kunststoff, kann in der Drehachse liegen und dadurch vollständig vom Betätigungsglied 1 abgedeckt sein. Das Zentrierglied greift zweckmäßig in eine komplementäre Öffnung des Betätigungsgliedes 1 gleitend ein, welche die Endfläche 3 durchsetzt und vom Glied 2 begrenzt sein kann. Zweckmäßig ist dabei das Sicherungsglied im Zentrum mit einem Durchbruch für den Strahlengang zwischen Lichtquelle 6 und Signaleingang 81 versehen. Das Sicherungsglied kann so angeordnet sein, daß es die Endfläche 3 in einem geringen Spaltabstand von der Platte 4 und somit das Betätigungsglied 1 gegenüber der Platte 4 berührungsfrei hält.

Ferner kann das Sicherungsglied auch zur axialen Abhebsicherung des Betätigungsgliedes 1 vorgesehen sein, beispielsweise über eine federnde Schnappverbindung, welche eine freie Drehbarkeit des Betätigungsgliedes 1 erlaubt, jedoch beim Abheben des Betätigungsgliedes 1 nur dann ausrückt, wenn eine entsprechend hohe Abhebkraft aufgewendet wird. Diese axiale Sicherung kann statt der magnetischen Sicherung oder zusätzlich zu dieser vorgesehen sein, wobei das Halteglied 7 auch am Sicherungsglied angeordnet sein und dann in einem Abstand vom Glied 2 liegen kann, der kleiner als die Dicke der Platte 4 ist.

In Fig. 3 ist im Querschnitt eine Glaskeramikplatte 31 dargestellt. Diese Platte verläuft beispielsweise bei einem Kochherd horizontal und dient zum Aufsetzen der Kochgefäße. An einer Stelle ist an der Unterseite 32 der Platte mit einer im einzelnen nicht dargestellten Halterung ein Magnet 33 angebracht. Der Magnet 33 liegt an der Unterseite 32 an. Seine magnetische Achse, d. h. die Verbindungslinie zwischen seinem Nordpol und seinem Südpol, verläuft senkrecht zu der Unterseite 32 der Platte 31 aus Glaskeramik. An der der Platte 31 abgewandten Stirnseite ist an dem Magneten 33 ein Blechteil 34 angebracht, das mehrere Arme 35 aufweist, die sich sternförmig nach außen erstrecken. Die Arme 35 sind in ihren Endbereichen der Platte 31 angenähert und bilden dort mehrere Magnetpole 36.

Zwischen dem Blechteil 34 und der Platte 31 ist eine Halterungsplatte 37 angebracht, die, ebenso wie der Magnet 33 und das Blechteil 34, ortsfest gehaltert ist. Auf der der Platte 31 zugewandten Seitenfläche sind auf der Halterungsplatte 37 mehrere Sensoren 38 angebracht, die nur schematisch dargestellt sein sollen.

Die Oberseite 39 der Platte 1 ist im Bereich des Magneten 33 genauso ausgebildet wie im übrigen Bereich, enthält also weder eine Vertiefung noch einen Durchbruch oder eine sonstige spezielle Ausbildung.

Auf die Oberseite 39 ist eine Bedienelement 40 aufgesetzt, das einen scheibenartigen Teil 41 mit einem Griffansatz 42 aufweist. Der Scheibenteil 41 wird an seiner Unterseite von einem Blechteil 43 begrenzt, das in seiner Form und Abmessung etwa dem Blechteil 34 an der Unterseite der Platte 31 entspricht. Auch hier sind die Enden 44 von Armen des Blechteiles der Platte 31 angenähert. An der Unterseite des Scheibenteils 41 ist unterhalb des Blechteils 43 ein in Form und Größe dem Magneten 33 entsprechendes Element 45 aus ferromagnetischem Material angebracht, insbesondere ebenfalls ein Magnet. Der Magnet ist ebenfalls so orientiert, daß seine magnetische Achse senkrecht zu der Auflagefläche verläuft, die von der einen Stirnseite des Magneten 45 gebildet wird. Die Orientierung des Magneten 45 ist genauso gewählt wie die Orientierung des Magneten 33 an der Unterseite der Platte 31, so daß der Nordpol des unteren Magneten 33 den Südpol des oberen Magneten 45 anzieht. Durch diese Anziehung wird der obere Magnet 45 und damit das ganze Bedienelement 40 bezüglich des unteren Magneten 33 zentriert. Mit Hilfe des Griffansatzes 42 kann das Bedienelement 40 um die magnetische Achse des unteren Magneten 33 verdreht werden. Dabei bleibt die Zentrierung erhalten, auch wenn ein Bediener den Griff seitlich zu verschieben versucht. Nur bei Aufwendung einer größeren seitlichen Kraft kann das Bedienelement von der Stelle des Magneten 33 weg bewegt werden.

Beim Verdrehen des Bedienelements 40 verschieben sich die von den Enden 44 der Arme des Blechteils 43 gebildeten Pole gegenüber den Sensoren 38, so daß mit Hilfe der Sensoren 38 eine Veränderung der Drehposition des Bedienelements 40 festgestellt werden kann.

Damit nicht nur eine Veränderung der Drehposition des Bedienelements 40 festgestellt werden kann, sondern auch die Drehrichtung, in der diese Veränderung erfolgt, sind, wie dies die Fig. 4 zeigt, zwei solcher Sensoren 38 vorhanden, die längs des Umfangs um die magnetische Achse so versetzt angeordnet sind, daß sie nicht gleichzeitig mit den Enden 44 der Arme des Blechteils 43 zusammenwirken.

Die Aufsicht der Fig. 4 zeigt ebenfalls das untere Blechteil 34 ohne den Magneten 33, mit den Armen 35 und den von den Enden 36 der Arme 35 gebildeten Magnetpolen. Wenn das obere Blechteil 43 die gleiche Zahl von Armen mit Magnetpolen aufweist, so werden die Magnetpole 36, 44 immer dann gegenseitig angezogen, wenn sie an der gleichen Umfangsposition angeordnet sind. Dies führt dazu, daß das Bedienelement im dargestellten Beispiel vier stabile Drehpositionen aufweist. Dies bildet eine berührungsfrei arbeitende Rastung des Bedienelements 40, die beim Verdrehen von dem Benutzer wahrgenommen wird. Zur Verstärkung dieser Wirkung können auch an den Enden der Arme eines oder beider Blechteile zusätzliche Magnete angebracht werden.

Mit Hilfe der Anordnung von zwei Sensoren 38 in der beschriebenen Weise kann also ermittelt werden, in welcher Richtung und um welchen Betrag das Bedienelement 40 verdreht wird. Es läßt sich auf diese Weise mit Hilfe einer Auswerteschaltung eine Änderung der Leistungseinstellung einer Kochplatte bewirken.

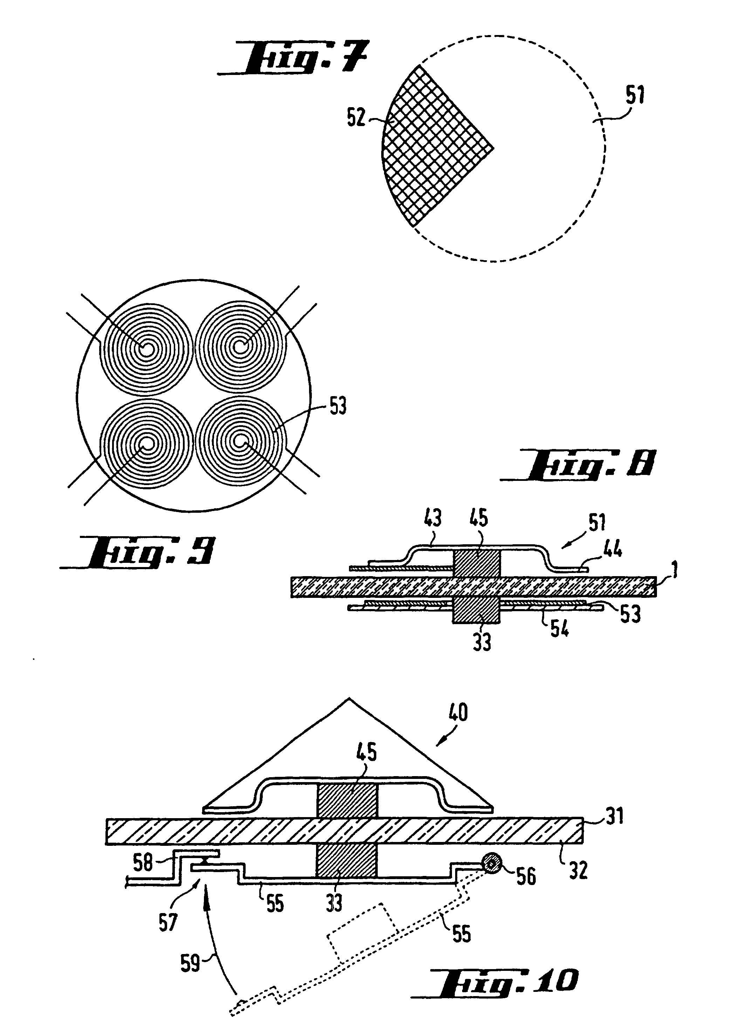

Während bei der Ausführungsform nach Fig. 3 der an der Unterseite der Platte 31 angeordnete Magnet 33 ortsfest und unverdrehbar angeordnet ist, ist bei der Ausführungsform der Fig. 5 an der Unterseite der Platte 31 ein Magnet 33 um eine ortsfeste Achse 46 verdrehbar gelagert. Einzelheiten der Drehlagerung sind nicht dargestellt. An der der Platte 31 abgewandten Seite des Magneten 33 ist mit diesem drehfest eine Scheibe 47 verbunden, die bei Verdrehung des Magneten 33 mit verdreht wird. Im Bereich des Umfangs 48 der Scheibe 47 sind zwei Sensoren 49 angeordnet, von denen einer oberhalb der Scheibe 47 und einer unterhalb der Scheibe 47 angeordnet ist. Die beiden Sensoren 49 können eine Änderung der Drehposition der Scheibe 47, gegebenenfalls auch die absolute Position der Scheibe 47 feststellen.

Auf der Oberseite der Platte 31 ist ein Bedienelement 40 angeordnet, das ähnlich aufgebaut ist wie das Bedienelement 40 der Ausführungsform nach Fig. 3, das jedoch unterhalb des Blechteils 43 einen Magneten 45 aufweist, dessen magnetische Achse parallel zu der Oberfläche der Platte 31 orientiert ist. Auch die magnetische Achse des unterhalb der Platte 31 angeordneten Magneten 33 ist parallel zu der Platte 31 angeordnet. Der obere Magnet 45 stellt sich antiparallel zu dem Magneten 33 auf der Unterseite und bleibt in dieser Position. Wird das Bedienelement 40 um die Achse 46 verdreht, so dreht sich der Magnet 33 und damit die Scheibe 47 mit. Die Sensoren 49 können daher die Änderung der Drehposition des Bedienelements 40 durch Ermitteln der Drehposition der Scheibe 47 mittelbar feststellen.

Fig. 6 zeigt eine separate Einschaltungvorrichtung, die mit dem Bedienelement aktiviert werden kann. Die Elektronik wird von der Netzspannung mit Strom versorgt. In der Zuleitung ist ein über ein Selbsthalterelais 50 ansteuerbarer Schalter enthalten. Parallel zu diesem Schalter ist ein Reedkontakt geschaltet. Wenn alle Stromverbraucher ausgeschaltet sind, öffnet sich nach kurzer Zeit das Selbsthalterelais. Dann kann eine Bewegung des oder der Bedienungselemente an den ihnen zugewiesenen Stellen nicht zum Wiedereinschalten der Stromversorgung dienen. Wenn die Einrichtung wieder eingeschaltet werden soll, ist es erforderlich, ein Bedienelement über den Reedkontakt zu schieben, so daß dieser geschlossen wird und die Elektronik mit Spannung versorgt. Dies führt dann zum Ansteuern des Selbsthalterelais, so daß jetzt eine Verdrehung der Bedienelemente an den zugeordneten Stellen zu einem Einschalten des Geräts führt.

Mit Hilfe dieser Einrichtung wird eine Abschaltautomatik möglich, die dann, wenn beispielsweise alle Kochplatten eines Herdes abgeschaltet sind, nach einer bestimmten Zeit die Elektronik insgesamt ausschaltet.

Während bei der Ausführungsform nach Fig. 3 die mit dem Bedienelement 40 verdrehten diskreten Magnetpole 44 zu einem Ansteuern der Sensoren 38 führen, ist bei dem Bedienelement 51 der Fig. 7 und 8 ein Sektor 52 aus einem metallischen Material vorhanden, der gegen über mehreren an der Unterseite der Platte 31 angeordneten Spulen 53 verdreht wird. Wird der Sektor 42 über eine bestimmte Spule 53 gedreht, so ändert sich deren Induktivität. Auf diese Weise kann die absolute Position des Bedienelements 51 festgestellt werden. Je nach Zahl der Spulen 53 kann eine mehr oder weniger genaue Ermittlung der absoluten Winkelposition des Bedienelements 51 erreicht werden. Bei der Ausführungsform nach Fig. 7 bis Fig. 9 sind die Spulen 53 als Sensorelement auf einer Platte 54 angebracht, die ortsfest gehalten wird. Zur Zentrierung des Bedienelements und zu dessen Festlegung dienen wieder ein an der Unterseite angeordneter Magnet 33 und ein dem Bedienelement zugeordneter oberer Magnet 45, dessen Unterseite gleichzeitig die Auflagefläche bildet. Wiederum können die Enden 44 von Armen des Blechteils 43 dazu verwendet werden, mit unterhalb der Platte 31 angeordneten Magnetpolen 36 eine Rastung des Bedienelements 51 zu bewirken.

In den Ausführungsformen wurden Sensoren dargestellt, die magnetisch oder auch optisch wirken. Es können selbstverständlich auch andere Sensoren verwendet werden, mit denen eine Änderung der Lage des Bedienelements festgestellt werden kann.

Fig. 10 zeigt eine Ausführungsform, die der Ausführungsform nach Fig. 3 ähnlich ist. Der an der Unterseite 32 der Platte 31 angeordnete Magnet 33 ist auf einem Halterungselement 55 befestigt, das seitlich an einer horizontalen Achse 56 schwenkbar angelenkt ist. Das Halterungselement 55 kann beispielsweise aus Metall bestehen und einen Teil eines Schalters 57 bilden. Der zweite Kontakt 58 ist ortsfest angeordnet. Wird das Halterungselement 55 nach unten verschwenkt, so öffnet sich der Schalter 57. Wird nun das Bedienelement 40 über die Stelle geschoben, wo der Magnet 33 liegt, so wird dieser von dem oberen Magneten 45 angezogen. Dies führt dazu, daß das Halterungselement 55 in Richtung des Pfeils 59 nach oben klappt und somit den Schalter 57 schließt. Auf diese Weise läßt sich durch Wegschieben des Bedienelements 40 eine galvanische Trennung bewirken. Dabei kann auch eine Forderung erfüllt werden, wonach im Trennzustand der Abstand der Kontakte des Schalters einen bestimmten Mindeswert von beispielsweise 3 mm haben soll. Selbstverständlich kann eine galvanische Trennung auch durch einen Reed-Schalter verwirklicht werden.

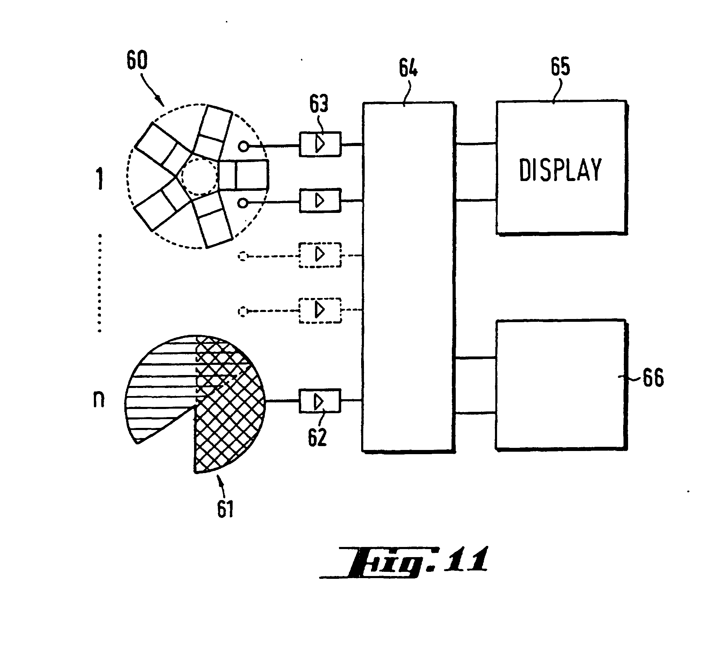

Fig. 11 zeigt schematisch die Anordnung mehrerer Ansteuerungen bei einem Elektrogerät, beispielsweise einem Herd. Zur Ansteuerung einer erste Kochplatte dient beispielsweise die Steueranordnung 60, während für eine zweite Kochplatte eine zweite Steueranordnung 61 dient. Die Steueranordnung 60 kann aufgebaut sein wie die Ausführungsform nach Fig. 3, während die Steueranordnung 61 von einer Art Drehkondensator gebildet wird. Selbsverständlich wird man bei einer bestimmten Art Elektrogerät nicht mehrere Arten von Ansteuerungen miteinander kombinieren. Hier soll nur gezeigt werden, daß verschiedene Steueranordnungen zum Ansteuern eines Geräts verwendet werden können. Die Ansteuerungen sind über Meßverstärker 62 oder Impulsformer 63 mit einer Auswertelogik 64 verbunden, die sowohl Anzeigen 65 als auch Leistungsschalter 66 ansteuert. Für jede Kochplatte ist ein eigener Leistungsschalter 66 vorhanden. Die Anzeige 65 dient zur Anzeige von Einstellungen der Kochplatten, ggf. auch zur Anzeige von Restwärme.

Die bereits erwähnte Verrastung, die magnetisch erzeugt wird, führt dazu, daß das rotierende Bedienelement nach Loslassen in einer definierten Position stehen bleibt. Das Bedienelement kann mit einem zentralen Magnet ausgebildet werden und mit einem mindestens zwei Arme aufweisenden Blechteil versehen werden. Ebenfalls möglich ist es, an den Enden der Arme des Blechteils zusätzliche Magnete vorzusehen.

Die Erfindung schlägt vor, das Bedienelement als Formteil aus dauermagnetischem Material herzustellen, dessen mindestens zwei Arme eine zum Zentrum gegensätzliche Polung aufweisen.

Die beim Drehen des Bedienelements auftretenden Magnetfeldveränderungen können zur Ansteuerung von darauf ansprechenden Sensoren genutzt werden. Diese Sensoren können Hall-Sensoren, Spulen, magnetoresistive Sensoren oder Reedkontakte sein. Außerdem kann die Ermittlung der Position des Bedienelements mittels kapazitiver, optischer, induktiver oder elektromagnetischer Wellen durchgeführt werden.

Die Auswertelogik wird derart ausgebildet, daß durch Drehen des Bedienelements ein minimaler und/oder maximaler Wert nicht unterschritten oder überschritten werden kann.

Wird das Bedienelement aus dem Bereich der Wirkung des unterhalb angeordneten Magneten seitlich entfernt, so wird die Ansteuerung des elektrischen Geräts insgesamt ausgeschaltet. Bei der Verwendung mehrerer Bedienelemente zum Ansteuern eines Kochfeldes oder mehrerer Kochplatten soll nur diejenige Kopfstelle ausgeschaltet werden, für die das Bedienelement entfernt wird.

Werden alle Bedienelemente auf null geschaltet, so erfolgt nach Ablauf einer vorgegebenen Zeitspanne ein vollständiges Abschalten der Einrichtung. Dann kann durch Drehen eines Bedienelements kein Einschalten mehr durchgeführt werden. Hierzu ist es vielmehr erforderlich, mindestens ein Bedienelement für eine bestimmte Zeit aus der Bedienposition seitlich herauszunehmen und anschließend wieder in die Bedienposition zurückzubringen.

## Patentansprüche

1. Anordnung zur Steuerung von elektrisch ansteuerbaren Geräten, insbesondere Elektrokochgeräten, mit
1.1 einer Platte (4, 31),
1.2 einer auf einer Seite der Platte (4, 31) angeordneten Einrichtung zur Erzeugung eines als Kraftfeld wirkenden Felds,
1.3 einem auf der gegenüberliegenden Seite der Platte angeordneten Bedienelement (1, 40),
1.4 einer Einrichtung zur Feststellung der Lage und/oder der Änderung der Lage des Bedienelements (1, 40),
**dadurch gekennzeichnet, dass**
1.5 die Platte (4, 31) keinerlei Öffnungen, Durchgänge, Vertiefungen, Halterungen oder dgl. aufweist,
1.6 die Einrichtung zur Erzeugung des Kraftfelds mindestens einen ortsfest gehaltenen Magneten (7, 33) oder einen bewegbar gehalterten Magneten (7, 33) aufweist und das Bedienelement (1, 40) ein mit diesem Magneten zusammenwirkendes Element (2, 45) aus ferromagnetischem Material aufweist,
1.7 die Anordnung des ortsfest gehaltenen Magneten (7, 33) oder eine Halterung für den bewegbar gehalterten Magneten (7, 33) den Freiheitsgrad der Bewegung definieren,
1.8 die Einrichtung zur Feststellung der Lage und/oder der Änderung der Lage des Bedienelements (1, 40) ausschließlich berührungsfrei mit dem Bedienelement zusammenwirkt,
1.9 das Bedienelement (1, 40) ausschließlich durch das Kraftfeld an der Platte (4, 31) ortsfest gehalten wird.

2. Anordnung nach Anspruch 1, bei der die Einrichtung zum Feststellen der Lage und/oder der Änderung der Lage des Bedienelements (1, 40) mindestens einen Sensor (5, 8, 38, 49) aufweist, der auf der gleichen Seite der Platte (4, 31) angeordnet ist wie die Einrichtung zur Erzeugung des Kraftfelds.

3. Anordnung nach Anspruch 1 oder 2, bei der zur Betriebs-Steuerung in Abhängigkeit von der jeweiligen Einstell-Lage des Betätigungsgliedes (1, 40) eine berührungsfreie Signalübertragung vorgesehen ist.

4. Anordnung nach Anspruch 3, bei der die Signalübertragung einen im Betätigungsglied (1, 40), wie einem Knebel, angeordneten Signalleiter, insbesondere einen strangförmigen Lichtleiter, enthält, der vorzugsweise bis auf einen Signaleingang (81) und/oder einen Signalausgang vollständig und festsitzend in das Betätigungsglied eingebettet ist und zwischen einem Signalgeber (6) sowie mindestens einem Signal-Empfänger (5) mindestens eine Signal-Übertragungsbrücke (8) bildet.

5. Anordnung nach Anspruch 3 oder 4, bei der bei mehreren Signal-Übertragungsbrücken (8) innerhalb des Betätigungsgliedes (1, 40) jeder Brücke (8) ein Bildmuster zugeordnet ist, welches entsprechend einer Bildmusterkodierung die Betriebs-Zustände, wie die Leistungsstufen, anwählt.

6. Anordnung nach einem der Ansprüche 3 bis 5, bei der der Signalleiter (8) aus Glasfasermaterial besteht und insbesondere seine Enden annähernd achsparallel gleichgerichtet etwa in derselben Ebene, wie der hinteren Endfläche (3) des Betätigungsgliedes (1, 40) liegen.

7. Anordnung nach einem der vorhergehenden Ansprüche, bei der das Betätigungsglied (1, 40) mehrere aneinander verstell- bzw. drehbar gelagerte Knebel-Teile enthält, von denen der am Grundkörper unmittelbar abgestützte Knebel-Sockel bei Knebel-Betätigung relativ zum Grundkörper festsitzend angeordnet und die andere, aufgesetzte Knebel-Einheit als Betätigungsglied zur manuellen Verstellung, wie zum Drehen, gegenüber dem Sockel und dem Grundkörper vorgesehen ist, wobei insbesondere der Signalleiter (8) an dem Betätigungsglied (1, 40) vorgesehen ist und die Signalübertragung den Knebel-Sockel durchsetzt.

8. Anordnung nach einem der vorhergehenden Ansprüche, bei der das Betätigungsglied (1, 40) gegen seitliches Verschieben formschlüssig gesichert ist, insbesondere durch ein auf dem Grundkörper haftend befestigtes Sicherungsglied, wie einen Kegel aus Kunststoff oder dgl., das in eine komplementär passende mittige Trichterform an der Knebelunterseite oder dgl. eingreift.

9. Anordnung nach einem der vorhergehenden Ansprüche, bei der der Sensor (5, 8, 38, 49) durch die gleiche physikalische Erscheinung beeinflußbar ist, die zum Festhalten des Bedienelements (1, 40) verwendet wird, insbesondere durch das zum Festhalten des Bedienelementes verwendete Kraftfeld, oder bei der der Sensor auf eine andere physikalische Erscheinung anspricht als die zum Festhalten des Bedienelements verwendete.

10. Anordnung nach einem der vorhergehenden Ansprüche, bei der das Bedienelement (1, 40) derart festgehalten wird, daß es in einem Freiheitsgrad bewegbar ist.

11. Anordnung nach einem der vorhergehenden Ansprüche, mit einer berührungsfrei arbeitenden Rasterung für die Bewegung des Bedienelements (1, 40).

12. Anordnung nach einem der vorhergehenden Ansprüche, mit einem Inkrementalgeber für die Bewegung des Bedienelements (1, 40).

13. Anordnung nach einem der vorhergehenden Ansprüche, mit einem Absolutgeber für die Bewegung des Bedienelements (1, 40).

14. Anordnung nach einem der vorhergehenden Ansprüche, mit einer Auswertelogik (64) und/oder mit einer Abschaltautomatik und/oder mit einem Hauptschalter (57).

15. Anordnung nach Anspruch 1, bei der an dem Magneten (7, 33) ein mindestens zwei Arme aufweisendes Blechteil (34) aus ferromagnetischem Material angebracht ist, dessen Arme (35) in ihrem Endbereich (36) der Platte (4, 31) angenähert sind und wobei insbesondere ein einziger Magnet (33) vorgesehen ist, dessen magnetische Achse senkrecht zu der Platte verläuft und eine Drehachse für das Bedienelement (1, 40) bildet.

16. Anordnung nach Anspruch 1 bei der mit dem Magneten (7, 33) ein Bauteil (34) mitbewegbar ist, dessen Bewegung von dem Sensor (5, 8, 38, 49) erfaßt wird, wobei insbesondere der Magnet verdrehbar gehaltert ist.

17. Anordnung nach einem der vorhergehenden Ansprüche, bei der das Bedienelement (1, 40) ein mindestens zwei Arme aufweisendes Blechteil (43) aus ferromagnetischem Material aufweist, dessen Arme in ihrem Endbereich der Platte (4, 31) angenähert sind.

18. Anordnung nach einem der vorhergehenden Ansprüche, bei der ein Magnet (7, 33) derart bewegbar gehaltert ist, daß er durch Wechselwirkung mit dem Bedienelement (1, 40) in seine Betriebsposition bewegbar und nach Wegnahme des Bedienelements in eine Warteposition bewegbar ist, wobei die Halterung für den Magneten beim Übergang von der Warteposition in die Betriebsposition einen galvanischen Schalter (57) betätigt.

## Claims

1. Arrangement for the control of electrically controllable appliances, particularly electric cooking appliances, having
1.1 a plate (4, 31),
1.2 a device for producing a field acting as a force field and located on one side of the plate (4, 31),
1.3 an operating element (1, 40) located on the opposite side of the plate,
1.4 a device for establishing the position and/or position change of the operating element (1, 40),
**characterized in that**
1.5 the plate (4, 31) has no openings, passages, depressions, holders or the like,
1.6 the device for producing the force field has at least one magnetic (7, 33) held in fixed manner or a magnet (7, 33) held in movable manner and the operating element (1, 40) has a ferromagnetic material element (2, 45) cooperating with said magnet,
1.7 the arrangement of the magnet (7, 33) held in fixed manner or a holder for the movably held magnet (7, 33) define the degree of freedom of movement,
1.8 the device for establishing the position or position change of the operating element (1, 40) cooperates in exclusively non-contacting manner with the operating element,
1.9 the operating element (1, 40) is held in fixed manner on the plate (4, 31) exclusively by the force field.

2. Arrangement according to claim 1, wherein the device for establishing the position and/or position change of the operating element (1, 40) has at least one sensor (5, 8, 38, 49), which is located on the same side of the plate (4, 31) as the device for producing the force field.

3. Arrangement according to claim 1 or 2, wherein a non-contacting signal transmission is provided for operating control as a function of the given setting position of the operating element (1, 40).

4. Arrangement according to claim 3, wherein the signal transmission contains a signal conductor, particularly a strand-like light guide located in the operating element (1, 40) and which can be a toggle, which preferably except for a signal input (81) and/or a signal output is embedded completely and in fixed manner in the operating element and forms at least one signal transmission bridge (8) between a signal generator (6) and at least one signal receiver (5).

5. Arrangement according to claim 3 or 4, wherein in the case of several signal transmission bridges (8) within the operating element (1, 40) an image pattern is associated with each bridge (8) and selects the operating states, such as power stages, in accordance with a pattern coding.

6. Arrangement according to one of the claims 3 to 5, wherein the signal conductor (8) is made from a glass fibre material and in particular its ends are located in approximately axially parallel, equidirectional manner in the same plane as the rear end surface (3) of the operating element (1, 40).

7. Arrangement according to one of the preceding claims, wherein the operating element (1, 40) contains several adjustable or rotatable toggle parts mounted on one another, whereof the toggle socket directly supported on the body in the case of toggle operation is fixed relative to said body and the other, mounted toggle unit is an operating member for manual adjustment, such as rotating, with respect to the socket and the body and in particular the signal conductor (8) is provided on the operating element (1, 40) and the signal transmission traverses the toggle socket.

8. Arrangement according to one of the preceding claims, wherein the operating element (1, 40) is positively secured against lateral displacement, particularly by a locking member adhesively fixed to the body, such as a comb made from plastic or the like and which engages in a complimentary matching, central funnel shape on the toggle underside or the like.

9. Arrangement according to one of the preceding claims, wherein the sensor (5, 8, 38, 49) can be influenced by the same physical phenomenon which is used for retaining the operating element (1, 40) and in particular by the force field used for retaining the operating element, or wherein the sensor responds to a physical phenomenon different to that used for retaining the operating element.

10. Arrangement according to one of the preceding claims, wherein the operating element (1, 40) is retained in such a way that it is movable in a degree of freedom.

11. Arrangement according to one of the preceding claims, having a grid system for the movement of the operating element (1, 40).

12. Arrangement according to one of the preceding claims, having an incremental transducer for the movement of the operating element (1, 40).

13. Arrangement according to one of the preceding claims, having an absolute transducer for the movement of the operating element (1, 40).

14. Arrangement according to one of the preceding claims, having an evaluation logic (64) and/or a automatic disconnection device and/or a master switch (57.

15. Arrangement according to claim 1, wherein to the magnet (7, 33) is fitted a ferromagnetic material, sheet metal part (34) having at least two arms (35), which approach the plate (4, 31) in the end region (36) thereof and where in particular a single magnet (33) is provided, whose magnetic axis is perpendicular to the plate and forms a rotation axis for the operating element (1, 40).

16. Arrangement according to claim 1, wherein with the magnet (7, 33) can move a component (34), whose movement is detected by the sensor (5, 8, 38, 49) and in particular the magnet is held in rotatable manner.

17. Arrangement according to one of the preceding claims, wherein the operating element (1, 4) has at least one ferromagnetic material sheet metal part (430 having at least two arms, which approach the plate (4, 31) in the end region thereof.

18. Arrangement according to one of the preceding claims, wherein a magnet (7, 33) is movable held in such a way that it can be moved into its operating position by interaction with the operating element (1, 4) and is movable into a waiting position after removing the operating element, the holder for the magnet operating a galvanic switch (57) on passing from the waiting position into the operating position.

## Revendications

1. Dispositif pour la commande d'appareils à commande électrique, notamment d'appareils pour la cuisson des aliments, avec
1.1 une plaque (4, 31 ),
1.2 disposé d'un côté de la plaque (4, 31 ), un moyen de génération d'un champ agissant en tant que champ de lignes de force,
1.3 un élément de réglage (1, 40) disposé du côté opposé de la plaque
1.4 qu'un moyen de constatation de la position et/ou du changement de position de l'élément de réglage (1, 40),
**caractérisé en ce que**
1.5 la plaque (4, 31) ne présente aucune ouverture, aucun passage, aucun creux, aucune attache ou similaires,
1.6 que le moyen de génération de champ de force présente au moins un aimant (7, 33) maintenu de manière stationnaire ou un aimant (7, 33) supporté de manière mobile et que l'élément de réglage (1, 40) présente un élément (2, 45) en matière ferromagnétique agissant avec cet aimant,
1.7 que la disposition de l'aimant (7, 33) maintenu de manière stationnaire ou un support pour l'aimant (7, 33) tenu de manière mobile définissent le degré de liberté de mouvement,
1.8 que le moyen de constatation de position et/ou du changement de position de l'élément de réglage (1, 40) agissent avec l'élément de réglage uniquement sans contact mécanique,
1.9 que l'élément de réglage (1, 40) est maintenu en lieu fixe sur la plaque (4, 31) exclusivement par le champ de force.

2. Dispositif d'après la revendication 1, pour lequel le moyen de constatation de la position et/ou du changement de position de l'élément de réglage (1, 40) présente au moins un détecteur (5, 8, 38, 49) disposé du même côté de la plaque (4, 31) que le moyen de génération du champ de force.

3. Dispositif d'après la revendication 1 ou 2, pour lequel on prévoit une transmission des signaux sans contact mécanique pour le réglage de l'activité en fonction de la position respective de réglage de l'élément de réglage (1, 40).

4. Dispositif d'après la revendication 3, pour lequel le moyen de transmission des signaux comprend une voie d'acheminement des signaux disposée dans l'élément de réglage (1, 40), telle une manette, notamment un guide de lumière en forme de fibres, qui est de préférence incorporé entièrement et de manière et fixe dans l'élément de réglage à l'exception d'une entrée de signal (81) et/ou d'une sortie de signal et qui forme au moins un pont de transmission (8) entre un poste transmetteur des signaux (6) et au moins un poste récepteur à signaux (5).

5. Dispositif d'après la revendication 3 ou 4, pour lequel, en cas de plusieurs ponts de transmission de signal (8) à l'intérieur d'un élément de réglage (1, 40), une structure d'image optique est associée à chaque pont (8), structure qui appelle des états de service spécifiques, tels que des niveaux de puissance, conformément à une codification des structures d'image optiques.

6. Dispositif d'après une des revendications de 3 à 5, pour lequel la voie d'acheminement des signaux (8) est constituée d'une matière à fibres de verre et dont notamment les extrémités se trouvent à peu près parallèles à l'axe, étant orientées dans le même sens et se trouvant à peu près dans le même plan, tel que dans la surface terminale (3) postérieure de l'élément de réglage (1, 40).

7. Dispositif d'après une des revendications précédentes, pour lequel l'élément de réglage (1, 40) comprend plusieurs éléments de manette logés l'un auprès de l'autre de manière mobile ou encore rotative, dont le socle de manette, s'appuyant directement sur le corps de base, est disposé pendant l'actionnement de la manette de manière fixe par rapport au corps de base et dont l'autre unité de manette placée au-dessus est prévue en tant qu'élément d'actionnement pour un réglage manuel, tel qu'une rotation, par rapport au socle et au corps de base, le moyen d'acheminement des signaux (8) étant notamment prévu auprès de l'élément de réglage (1, 40) et la transmission des signaux traversant le socle de manette.

8. Dispositif d'après une des revendications précédentes, pour lequel l'élément de réglage (1, 40) est assuré à engagement positif contre un déplacement latéral, notamment par un élément d'assurage fixé de manière adhérente au corps de base, tel qu'un cône en matière plastique ou similaires, qui s'engage dans une forme d'entonnoir centrique, adaptée de manière complémentaire, à la face inférieure de manette ou similaires.

9. Dispositif d'après une des revendications précédentes, pour lequel le détecteur (5, 8, 38, 49) peut être influencé par le même phénomène physique que celui qui est employé pour maintenir l'élément de réglage (1, 40), notamment par le champ de force utilisé pour maintenir l'élément de réglage, ou pour lequel le détecteur réagit à un autre phénomène physique qu'à celui qui est employé pour maintenir l'élément de réglage.

10. Dispositif d'après une des revendications précédentes, pour lequel l'élément de réglage (1, 40) est maintenu de manière qu'il peut être déplacé à un degré de liberté.

11. Dispositif d'après une des revendications précédentes avec un crantage opérant sans contact, pour le mouvement de l'élément de réglage (1, 40).

12. Dispositif d'après une des revendications précédentes avec un transmetteur incrémental pour le mouvement de l'élément de réglage (1, 40).

13. Dispositif d'après une des revendications précédentes avec un transmetteur de position absolue pour le mouvement de l'élément de réglage (1, 40).

14. Dispositif d'après une des revendications précédentes avec une logique d'évaluation (64) et/ou avec un automatisme pour la mise hors de service et/ou avec un commutateur principal (57).

15. Dispositif d'après la revendication 1, pour lequel un élément en tôle (34) en matière ferromagnétique présentant au moins deux bras est appliqué à l'aimant (7, 33), élément en tôle dont les bras (35) sont approchés de la plaque (4, 31 ) dans leur domaine terminal (36) et étant prévu notamment un seul aimant (33), dont l'axe magnétique s'étend orthogonalement par rapport à la plaque et forme un axe de rotation pour l'élément de réglage (1, 40).

16. Dispositif d'après la revendication 1, pour lequel un élément constructif (34) peut être déplacé avec l'aimant (7, 33), élément dont le mouvement est détecté par le détecteur (5, 8, 38, 49), l'aimant notamment étant maintenu de manière rotative.

17. Dispositif d'après une des revendications précédentes, pour lequel l'élément de réglage (1, 40) présente un élément en tôle (43) en matière ferromagnétique présentant au moins deux bras, dont les bras sont approchés de la plaque (4, 31) dans leur domaine terminal.

18. Dispositif d'après une des revendications précédentes, pour lequel un aimant (7, 33) est maintenu de manière mobile de manière qu'il puisse être déplacé dans sa position de service par l'interaction avec l'élément de réglage (1, 40) et qu'il puisse être déplacé dans une position de repos à la suite de l'enlèvement de l'élément de réglage, le support de l'aimant actionnant un commutateur (57) galvanique au moment de la transition de la position de repos à la position de service.
